# EUROPEAN PATENT APPLICATION

(11) **EP 4 580 325 A1**
(43) Date of publication of application: **02.07.2025**
(21) Application number: 23866867.7
(22) Date of filing: 31.03.2023
(51) Int. Cl.: H05K 7/20

(54) **LIQUID COOLING SYSTEM AND CONTROL METHOD THEREFOR**

(30) Priority: 23.09.2022 CN 202211170946
(71) Applicant: ZTE CORPORATION, Shenzhen, Guangdong 518057 (CN)
(72) Inventor: FAN, Haolong, Shenzhen, Guangdong 518057 (CN); LIU, Fan, Shenzhen, Guangdong 518057 (CN); LU, Zhiyao, Shenzhen, Guangdong 518057 (CN)
(74) Representative: Ziebig Hengelhaupt Intellectual Property Attorneys Patentanwaltskanzlei PartGmbB
(86) International application number: PCT/CN2023/085416
(87) International publication number: WO 2024/060570

(57) **Abstract**

Disclosed are a liquid cooling system and a control method therefor, applicable to the field of heat dissipation. The liquid cooling system comprises: a circulating main system, the circulating main system comprising a loop formed by sequentially connecting a medium cooling unit, an outer circulating pump, and a device cooling unit by means of pipelines; and a pressurizing subsystem and a liquid supplementing pipeline. The pressurizing subsystem comprises a first electric valve, a liquid supplementing tank, a liquid supplementing pump, and a pressure balance pipeline; the liquid supplementing tank is connected to the circulating main system by means of the liquid supplementing pipeline; the liquid supplementing pump is provided on the liquid supplementing pipeline; the pressure balance pipeline is further connected to the liquid supplementing tank; and the first electric valve is provided on the pressure balance pipeline so as to control on/off of the pressure balance pipeline.

## Description

### CROSS-REFERENCE TO RELATED APPLICATIONS

The present disclosure claims priority of Chinese patent application CN202211170946.3, filed on September 23, 2022, entitled "Liquid cooling system and control method therefor", the entirety of which is incorporated into the present disclosure by reference.

### TECHNICAL FIELD

The present disclosure relates to the field of heat dissipation, in particular to a liquid cooling system and a control method therefor.

### BACKGROUND

With the development of the electronic industry, devices such as servers and switches are gradually increased, and in order to ensure the continuous high-performance operation of the devices, it is necessary to dissipate heat from the devices. In order to actively promote the green and low-carbon transformation and sustainable development of the economy, heat dissipation schemes in the information and communication technology industry have accelerated the research and deployment of a liquid cooling technology. The liquid cooling heat dissipation technology in which heat is dissipated from the devices by means of medium circulation is more energy-saving and environmentally friendly than other heat dissipation schemes.

### SUMMARY

The present disclosure provides a liquid cooling system and a control method therefor.

In a first aspect, the present disclosure provides a liquid cooling system, including: a circulating main system, where the circulating main system includes a loop formed by sequentially connecting a medium cooling unit, an outer circulating pump, and a device cooling unit by means of pipelines, the medium cooling unit cools a medium in the circulating main system, and the device cooling unit absorbs heat radiated from a device; and a pressurizing subsystem and a liquid supplementing pipeline, where the pressurizing subsystem includes a first electric valve, a liquid supplementing tank, a liquid supplementing pump, and a pressure balance pipeline, the liquid supplementing tank is connected to the circulating main system by means of the liquid supplementing pipeline, the liquid supplementing pipeline is provided with the liquid supplementing pump, the pressure balance pipeline is further connected to the liquid supplementing tank, and the first electric valve is disposed on the pressure balance pipeline to control connection and disconnection of the pressure balance pipeline.

In a second aspect, the present disclosure further provides a control method for a liquid cooling system, including: acquiring a pressure of the circulating main system; and in the case where the pressure is lower than a first set pressure value, controlling a first electric valve to be opened, and controlling a liquid supplementing pump to be turned on to supplement liquid to the circulating main system; or in the case where the pressure is not lower than the first set pressure value, controlling the liquid supplementing pump to be turned off, and controlling the first electric valve to be closed.

### BRIEF DESCRIPTION OF DRAWING(S)

In order to illustrate the technical solutions in the embodiments of the present disclosure or the related art more clearly, the drawings which are required to be used in the description of the embodiments or the related art will be briefly introduced below. Obviously, the drawings in the following description are merely some embodiments of the present disclosure. For those of ordinary skill in the art, other drawings can also be obtained according to the structures shown in these drawings without inventive steps.
FIG. 1 is a schematic structural diagram of a liquid cooling system according to an embodiment of the present disclosure;
FIG. 2 is a schematic structural diagram of a liquid cooling system according to another embodiment of the present disclosure;
FIG. 3 is a first flow chart of a control method for the liquid cooling system according to an embodiment of the present disclosure;
FIG. 4 is a second flow chart of the control method for the liquid cooling system according to the embodiment of the present disclosure; and
FIG. 5 is a third flow chart of the control method for the liquid cooling system according to the embodiment of the present disclosure.

Description of reference numerals: 10: circulating main system; 11: medium cooling unit; 12: outer circulating pump; 13: degassing device; 14: expansion tank; 15: pipeline monitoring sensor; 20: pressurizing subsystem; 21: liquid supplementing tank; 22: first electric valve; 23: pressure balance pipeline; 24: dry filter; 25: liquid supplementing pump; 30: pressure relief subsystem; 31: **safety valve;** 32: throttling pipe; 33: pressure relief pipeline; 34: second electric valve; 35: medium recovery device; 40: liquid supplementing pipeline; 41: purification module; 42: liquid supplementing valve; 50: control end

### DETAILED DESCRIPTION

The technical solutions in the embodiments of the present disclosure will be clearly and completely described below in conjunction with the accompanying drawings in the embodiments of the present disclosure. Obviously, the described embodiments are only a part of the embodiments of the present disclosure, rather than all of the embodiments. Based on the embodiments in the present disclosure, all other embodiments obtained by those of ordinary skill in the art without making inventive step belong to the scope of protection of the present disclosure.

It should be noted that all directionality indications (such as up, down, left, right, front, back) in the embodiments of the present disclosure are only used to explain the relative positional relationship, movement situation, etc. between components in a certain particular posture, and if the particular posture is changed, the directionality indications are changed accordingly.

It should also be noted that when an element is referred to as being "fixed to" or "disposed on" another element, it can be directly on the other element or an intervening element may also be present. When an element is referred to as being "connected" to another element, it can be directly connected to the other element or indirectly connected to the other element through an intervening element.

In addition, descriptions relating to "first", "second", etc. in the disclosure are for descriptive purposes only, and cannot be understood to indicate or imply relative importance thereof or to implicitly specify the number of technical features indicated. Thus, features defined by "first" and "second" may explicitly or implicitly include at least one of such features. In addition, the technical solutions of the embodiments may be combined with each other, but must be based on being implemented by those of ordinary skill in the art. Such combination of the technical solutions should be considered to be absent and not within the scope of protection claimed in the present disclosure when the combination of the technical solutions contradicts each other or cannot be implemented.

At present, in the process of adopting a liquid cooling heat dissipation system, it is necessary to ensure that a pressure value in the system is appropriate and stable. On one hand, it is necessary to avoid the risk of pump cavitation due to a too low pressure of the system, and on the other hand, it is also necessary to avoid too high pressure, causing the problem of the running risk of the whole system. Thus, liquid supplementing and pressurization are required to be performed when the pressure of the liquid cooling heat dissipation system is too low, and liquid discharge and pressure relief are required to be performed when the pressure of the liquid cooling heat dissipation system is too high.

However, in some cases, a liquid supplementing tank in a liquid cooling heat dissipation system communicates with outside air, which causes moisture and impurities in the air to enter the liquid cooling heat dissipation system, resulting in a poor heat dissipation effect of the whole system, and in the case where the liquid supplementing tank is not sealed, dissipation of the stored medium will also be caused.

Since the liquid cooling heat dissipation system dissipates heat from a device by medium circulation, during the operation of the system, when the pressure of the liquid cooling heat dissipation system is too low, it is necessary to supplement a medium to the liquid cooling heat dissipation system for liquid supplementing and pressure increasing, so as to ensure that the pressure in the system is appropriate and stable. Therefore, a liquid cooling system and a control method therefor provided by the present disclosure can perform liquid supplementing and pressurization on a circulating main system through a pressurizing subsystem.

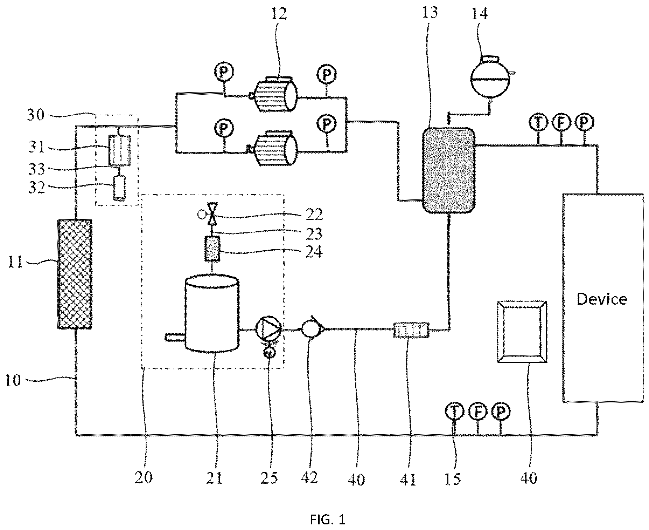

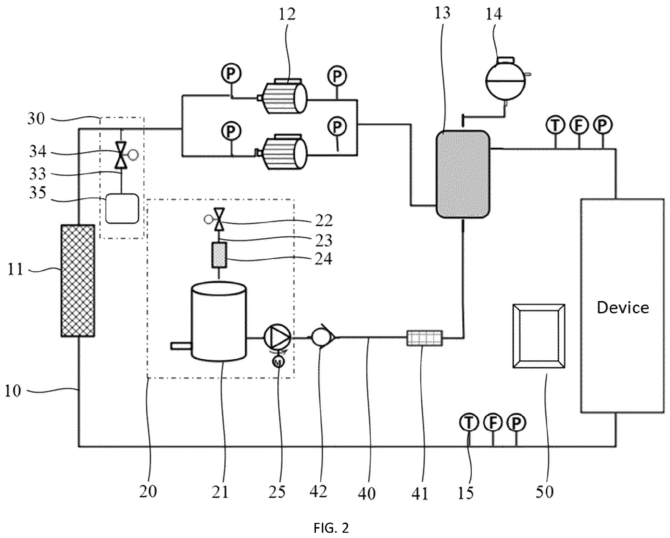

As shown in FIGS. 1 and 2, a liquid cooling system provided in an embodiment of the present disclosure includes a circulating main system 10, a pressurizing subsystem 20, and a liquid supplementing pipeline 40. The circulating main system 10 is a circulating loop for a medium, and the pressurizing subsystem 20 may supplement a medium to the circulating main system 10 by means of the liquid supplementing pipeline 40 to increase the pressure within the circulating main system 10. It should be noted that the medium described herein may be a cooling medium such as a fluorinated liquid, deionized water or an alcohol-based solution.

The circulating main system 10 includes a loop formed by sequentially connecting a medium cooling unit 11, an outer circulating pump 12, and a device cooling unit by means of pipelines, the medium cooling unit 11 cools a medium in the circulating main system 10, and the device cooling unit absorbs heat radiated from a device.

The medium cooling unit 11 may be a heat exchanger that cools the medium by heat exchange with the outside to ensure that the device is cooled during medium circulation. Optionally, the medium in the medium cooling unit 11 may be cooled by air cooling, or the medium in the medium cooling unit 11 may be cooled by water cooling, which is not limited in the present disclosure. In addition, the device cooling unit is disposed in the device, and may also be a heat exchanger that cools the device by absorbing heat radiated from the device. Optionally, the device cooling unit may be a cold plate liquid cooling structure, an immersion liquid cooling structure or a spray liquid cooling structure, which is not limited in the present disclosure. In addition, the device described herein may be a device such as a server, a router, a switch, and a BBU (Baseband Processing Unit), which is not limited herein.

In the circulating main system 10, the medium circulates in the loop through the outer circulating pump 12 to continuously cool the device. In the present disclosure, the flowing direction of the medium is not limited as long as circulation is achieved. Optionally, the medium in the circulating main system 10 sequentially circulates along the device cooling unit, the outer circulating pumps 12 and the medium cooling unit 11.

Additionally, in the pressurizing subsystem 20, the pressurizing subsystem 20 includes a first electric valve 22, a liquid supplementing tank 21, a liquid supplementing pump 25, and a pressure balance pipeline 23. The liquid supplementing tank 21 is connected to the circulating main system 10 by means of the liquid supplementing pipeline 40, the liquid supplementing pipeline 40 is provided with the liquid supplementing pump 25, and the pressure balance pipeline 23 is further connected to the liquid supplementing tank 21. The first electric valve 22 is disposed on the pressure balance pipeline 23 to control connection and disconnection of the pressure balance pipeline 23.

The medium is stored in the liquid supplementing tank 21, and the liquid supplementing tank 21 itself is provided with a pressure balance port, a liquid adding port, a liquid discharging port and a liquid supplementing port. The pressure balance port is configured to be connected to the pressure balance pipeline 23. The liquid adding port is configured to supplement a medium and can be opened or closed by means of a valve or a cap. Or, in other embodiments, the liquid adding port is the pressure balance port, which achieves pressure balance between inside and outside by means of the pressure balance pipeline 23, and may be also used to add liquid when liquid is needed to be added. The liquid discharging port is configured to discharge the medium and can be opened or closed by a valve or cap. The liquid supplementing port is then connected to the circulating main system 10 by means of the liquid supplementing pipeline 40 to supplement a medium to the circulating main system 10 through the liquid supplementing pump 25. Optionally, the pressure balance port and the liquid adding port are disposed at the top of the liquid supplementing tank 21, and the liquid discharging port and the liquid supplementing port are disposed at the bottom of a side wall of the liquid supplementing tank 21.

The liquid supplementing pump 25 herein may be selected according to the type of the medium in the liquid cooling system, and may be a mechanical pump or a shield pump, which is not limited herein.

The first electric valve 22 may be electrically controlled to be opened or closed to control connection and disconnection of the pressure balance pipeline 23. In the case where the first electric valve 22 is opened, the pressure balance pipeline 23 is connected, so that the liquid supplementing tank 21 communicates with the outside; and in the case where the first electric valve 22 is closed, the pressure balance pipeline 23 is disconnected, so that the liquid supplementing tank 21 is isolated from the outside.

In this embodiment, in the case where liquid supplementing is needed in the circulating main system 10, the medium inside the liquid supplementing tank 21 can be drawn by means of the liquid supplementing pump 25 to supplement the medium to the circulating main system 10, and after the first electric valve 22 is opened, air is input by the pressure balance pipeline 23, and the air pressure balance of the liquid supplementing tank 21 can be ensured ; while in the case where liquid supplementing is not needed, the pressure balance pipeline 23 is disconnected by the first electric valve 22, so that external moisture or impurities can be avoided from entering the liquid supplementing tank 21, contamination of the medium is prevented, and at the same time dissipation of the medium stored in the liquid supplementing tank 21 is prevented.

As shown in FIGS. 1 and 2, in some optional embodiments of the present disclosure, the pressurizing subsystem 20 further includes a dry filter 24, the dry filter 24 is disposed on the pressure balance pipeline 23, the dry filter 24 is located between the first electric valve 22 and the liquid supplementing tank 21, and the dry filter 24 dries air which passes through the pressure balance pipeline 23.

During liquid supplementing and pressure increasing of the circulating main system 10, the first electric valve 22 is opened, the liquid supplementing tank 21 communicates with the outside, and air flows into the liquid supplementing tank 21 along the pressure balance pipeline 23 to ensure that the pressure in the liquid supplementing tank 21 is constant. However, moisture or impurities are often entrained in the air. At this time, the dry filter 24 is disposed on the pressure balance pipeline 23 through which the air flows. The dry filter 24 is provided with a filter screen, a molecular sieve, a desiccant, etc. to filter out the moisture or impurities in the air to avoid contamination of the medium in the liquid supplementing tank 21. In other embodiments, the pressure balance pipeline 23 may also be provided directly with a filter screen in the inside or filled with a desiccant, and the like, which will not be described in detail.

In some optional embodiments, a filter screen may be disposed directly in the liquid supplementing tank 21, the medium passes through the filter screen to settle below the filter screen, and the liquid supplementing port is disposed at the side of the bottom of the liquid supplementing tank 21, so that impurities in a medium flowing out from the liquid supplementing port are filtered out, further reducing impurities in the medium flowing into the circulating main system 10.

As shown in FIGS. 1 and 2, in some optional embodiments of the present disclosure, the liquid cooling system further includes a purification module 41, the purification module 41 is disposed on the liquid supplementing pipeline 40, and the purification module 41 treats impurities in a cooling medium.

Here, the purification module 41 is configured to treat the medium supplemented to the circulating main system 10, for example, by adsorption through activated carbon, to filter out impurities in the medium, thereby ensuring that the medium flowing into the main circulating system 10 is not mixed with impurities, thereby ensuring stable operation of the liquid cooling system.

In the present disclosure, the liquid supplementing pump 25 and the purification module 41 are sequentially disposed on the liquid supplementing pipeline 40 in the direction from the liquid supplementing tank 21 to the circulating main system 10. Optionally, the liquid supplementing pipeline 40 is also provided with a liquid supplementing valve 42, so that in the case where liquid supplementing is not needed, the liquid supplementing valve 42 is closed to prevent free flow of the medium between the liquid supplementing tank 21, the liquid supplementing pipeline 40 and the circulating main system 10. Optionally, the liquid supplementing pump 25, the liquid supplementing valve 42 and the purification module 41 are sequentially disposed on the liquid supplementing pipeline 40 in the direction from the liquid supplementing tank 21 to the circulating main system 10.

Additionally, in yet some optional embodiments, a purification module 41 may also be disposed in the circulating main system 10, and may, for example, be disposed on a pipeline of the circulating main system 10 to directly treat impurities in the medium circulating in the circulating main system 10, and the purification module 41 may be of a unified structure with the purification module 41 on the liquid supplementing pipeline 40, that is, one part of the purification module 41 treats impurities in the medium supplemented in the liquid supplementing pipeline 40, and the other part of the purification module 41 treats impurities in the medium circulating in the circulating main system 10.

As shown in FIGS. 1 and 2, in some optional embodiments of the present disclosure, the circulating main system 10 further includes a degassing device 13, the medium cooling unit 11, the outer circulating pumps 12, the degassing device 13, and the device cooling unit are connected sequentially by means of pipelines to form the loop, and the liquid supplementing pipeline 40 is connected to the degassing device 13, and the degassing device 13 separates gas in the circulating main system 10.

In the circulating main system 10, in order to ensure that the entire loop is filled with the medium in the circulating main system 10, the degassing device 13 can separate the medium from the gas, thus facilitating reliable operation of the outer circulating pump 12. The degassing device 13 includes a degassing tank, one end of the degassing tank is allowed a medium to enter, after the medium enters the degassing tank, the gas floats up and is separated from the medium, and the negative pressure in the degassing tank can be further caused by a vacuuming device to release all dissolved gas in a liquid, and the other end of the degassing tank is allowed the medium to be discharged, and the medium enters the circulating main system 10 again for circulation.

In the present disclosure, the aforementioned liquid supplementing tank 21 is connected to the degassing device 13 of the circulating main system 10 through the liquid supplementing pipeline 40, so that the medium supplemented from the liquid supplementing tank 21 is first separated from the gas, it is ensure that the medium supplemented into the loop for circulation does not contain gas, the medium can fill the entire loop, and reliable operation of the outer circulating pump 12 is ensured. Optionally, the liquid supplementing pipeline 40 is connected to the bottom of the degassing tank of the degassing device 13 to stably fill the medium and separate the medium from the gas.

In embodiments of gas, the liquid supplementing tank 21 may also be directly connected to a pipeline of the circulating main system 10 by means of the liquid supplementing pipeline 40 to supplement the medium of the circulating main system 10.

In accordance with the above degassing device 13, in some optional embodiments of the present disclosure, the liquid cooling system further includes an expansion tank 14, the expansion tank 14 is connected to the degassing device 13 to receive separated gas in the degassing device 13, and the expansion tank 14 carries out buffering and pressure stabilizing.

The top of the degassing tank of the degassing device 13 is provided with an exhaust port which is connected to the expansion tank 14 by means of an exhaust pipe, so that the gas separated by the degassing device 13 enters the expansion tank 14 along the exhaust pipe to carry out buffering and pressure stabilizing, the pressure inside the circulating main system 10 is prevented from being affected by excessive fast gas exhaust, and pressure balance is ensured for the operation of the liquid cooling system. On the other hand, by the disposed expansion tank 14, contact of ambient air with the medium is also avoided, it is ensured that impurities do not enter the medium in the circulating main system 10.

In other optional embodiments, a vent valve may be disposed at the exhaust port at the top of the degassing tank of the degassing device 13, and after separation of the gas from the degassing tank, the vent valve may be directly pushed open to exhaust the gas.

As shown in FIGS. 1 and 2, in the present disclosure, the liquid cooling system further includes a pressure relief subsystem 30. When the pressure within the circulating main system 10 is too high, the medium may be discharged through the pressure relief subsystem 30 to ensure pressure balance within the circulating main system 10.

As shown in FIG. 1, in some optional embodiments, the pressure relief subsystem 30 includes a safety valve 31, a throttling pipe 32, and a pressure relief pipeline 33, a first end of the pressure relief pipeline 33 is connected to the circulating main system 10, the safety valve 31 and the throttling pipe 32 are disposed on the pressure relief pipeline 33, the safety valve 31 is located between the circulating main system 10 and the throttling pipe 32, and the throttling pipe 32 restricts the flow rate of discharged medium.

The safety valve 31 can be designed according to the safety pressure of the system, that is, in the case where the pressure inside the circulating main system 10 reaches a certain value, the medium inside will exert pressure on the safety valve 31. Under this pressure, the safety valve 31 will be opened to discharge the medium in the circulating main system 10 to achieve pressure relief, and when the pressure reaches a threshold value of balance, the safety valve 31 is not opened due to the decrease of the pressure applied to the safety valve 31, and the safety valve 31 is closed to stop discharge of the medium. In this way, there is no need for human control, and pressure relief is accurate and convenient.

Moreover, the throttling pipe 32 is also disposed behind the safety valve 31, which can play a throttling role to prevent that excessive high-pressure medium is discharged in the process of opening the safety valve 31 for pressure relief, and ensure stable and slow discharge of the medium, thereby minimizing the loss of the medium in the circulating main system 10 due to the pressure relief. Optionally, the throttling pipe 32 is a device that reduces the circulation amount of the medium and plays a throttling role, such as a reducer and a variable diameter tube.

As shown in FIG. 2, in yet other optional embodiments, the pressure relief subsystem 30 includes a second electric valve 34 and a pressure relief pipeline 33, a first end of the pressure relief pipeline 33 is connected to the circulating main system 10, and the second electric valve 34 is disposed on the pressure relief pipeline 33.

The second electric valve 34 can be electrically controlled to be opened or closed. When the pressure in the circulating main system 10 is too high, the second electric valve 34 can be opened to achieve pressure relief. Furthermore, since an opening degree of the second electric valve 34 can be adjusted according to the control, a high pressure in the circulating main system 10 can be set to multiple levels as needed, each level corresponds to one opening degree of the second electric valve 34. Thus, during the process of pressure relief when the pressure in the circulating main system 10 is too high, in the case where the pressure exceeding the balance is not large, the opening degree of the second electric valve 34 is small, and stable pressure relief can be achieved, and in the case where the pressure exceeding the balance is too large, the opening degree of the second electric valve 34 will also increase, so that the pressure relief process can be precisely controlled to avoid the discharge of excessive high-pressure mediums during the pressure relief process.

As described above, in some optional embodiments of the present disclosure, the pressure relief subsystem 30 further includes a medium recovery device 35, and a second end of the pressure relief pipeline 33 is connected to the medium recovery device 35.

In this way, a medium discharged due to pressure relief in the circulating main system 10 can be recovered by the medium recovery device 35 to reduce waste and be recycled.

In yet other optional embodiments, the second end of the pressure relief pipeline 33 may be connected directly to the liquid supplementing tank 21, for example, connected to the liquid supplementing port of the liquid supplementing tank 21, and in this way, the medium discharged from the circulating main system 10 is directly returned to the liquid supplementing tank 21 for liquid supplementing when liquid supplementing is required next time, and is directly recycled to reduce the need for manual liquid supplementing. It should be noted that in order to ensure pressure balance in the liquid supplementing tank 21, the first electric valve 22 can be opened simultaneously while the medium is supplemented to the liquid supplementing tank 21, and here, the first electric valve 22 is opened simultaneously during the pressure relief process.

As shown in FIGS. 1 and 2, in the present disclosure, at least one outer circulating pump 12 is provided, and in some optional embodiments, a plurality of the outer circulating pumps 12 are provided, and the plurality of the outer circulating pumps are arranged in parallel, and the medium cooling unit 11, the plurality of the outer circulating pumps 12 arranged in parallel, and the device cooling unit are connected sequentially by means of pipelines to form the loop.

Inlet ends of the plurality of the outer circulating pumps 12 are connected by pipelines and outlet ends of the plurality of the outer circulating pumps 12 are connected by pipelines so that the plurality of the outer circulating pumps 12 are arranged in parallel in the circulating main system 10. By providing the plurality of the outer circulating pumps 12, power supplied to the medium circulation is increased, and stable circulation of the medium is ensured. Optionally, dual pumps are arranged in parallel within the circulating main system 10.

As shown in FIGS. 1 and 2, in addition, the liquid cooling system further includes a control end 50 and a pipeline monitoring sensor 15 disposed on the circulating main system 10, both the pipeline monitoring sensor 15 and the first electric valve 22 are connected to the control end 50, and the control end 50 controls the first electric valve 22 according to monitoring information of the pipeline monitoring sensor 15.

The pipeline monitoring sensor is configured to monitor various data of the circulating main system 10 to ensure safe and stable circulation of the medium within the circulating main system 10, and in some optional embodiments of the present disclosure, the pipeline monitoring sensor 15 includes a temperature sensor at an outlet of the device, a flow sensor at the outlet of the device, a pressure sensor at the outlet of the device, a temperature sensor at an inlet of the device, a flow sensor at the inlet of the device, a pressure sensor at the inlet of the device, a pressure sensor behind the pump, and a pressure sensor in front of the pump to monitor the temperature, flow rate, and pressure at the outlet of the device as well as the temperature, flow rate, and pressure at the inlet of the device, and the pressures at the outlet and inlet ends of the outer circulating pump 12, respectively.

The control end 50 is wiredly or wirelessly connected to the pipeline monitoring sensor 15 to obtain monitored data, and optionally, the monitored data may be displayed through a display panel, and the liquid cooling system may be controlled based on the data to ensure safe and stable operation of the circulating main system 10. In this embodiment, by monitoring the pressure at each position of the circulating main system 10, the medium is supplemented for pressurization when the pressure is too low, and the medium is discharged for pressure relief when the pressure is too high, so as to maintain the balance of the pressure in the circulating main system 10 and ensure the safe and stable operation of the circulating main system 10.

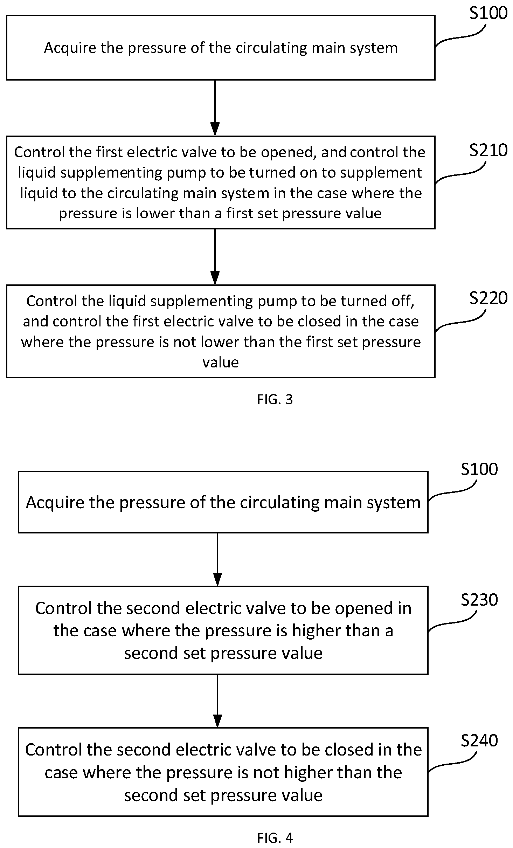

As shown in FIG. 3, based on the above liquid cooling system, an embodiment of the present disclosure also provides a control method for the liquid cooling system, including Step S100, and Step S210 or Step S220.

In S100, the pressure of the circulating main system 10 is acquired. The pressure is acquired by the aforementioned pipeline monitoring sensor 15 such as the pressure sensor at the outlet of the device, the pressure sensor at the inlet of the device, the pressure sensor behind the pump, and the pressure sensor in front of the pump, and the pressure here may be a set of pressures monitored at a plurality of positions or an average of the pressures monitored at a plurality of positions. In embodiments of the present disclosure, in the case where the pressure is a set of pressures monitored at a plurality of positions, a minimum pressure is used as the pressure here during pressurization.

In S210, in the case where the pressure is lower than a first set pressure value, the first electric valve 22 is controlled to be opened, and the liquid supplementing pump 25 is controlled to be turned on to supplement a liquid to the circulating main system 10. During liquid supplementing, as the liquid level of the liquid supplementing tank 21 decreases, the pressure inside the liquid supplementing tank 21 will be also reduced, and when the pressure is lower than the external ambient pressure, air passes through the first electric valve 22 along the pressure balance pipeline 23, and then passes through the aforementioned dry filter 24 to remove moisture and impurities, and finally the treated dry and clean air enters the liquid supplementing tank 21 to ensure the pressure balance of the liquid supplementing tank 21 during liquid supplementing. Optionally, in the case where the pressure is lower than the first set pressure value, the first electric valve 22 is first controlled to be opened and then the liquid supplementing pump 25 is controlled to be turned on to ensure the pressure balance inside the liquid supplementing tank 21. In addition, in the case of disposing the liquid supplementing valve 42 on the liquid supplementing pipeline 40, it is also necessary to ensure that the liquid supplementing valve 42 is in an open state by manual or electrical control.

In S220, in the case where the pressure is not lower than the first set pressure value, the liquid supplementing pump 25 is controlled to be turned off, and the first electric valve 22 is controlled to be closed. At this time, the pressure in the circulating main system 10 reaches a balance state, the liquid supplementing is stopped, and the first electric valve 22 is closed, thereby effectively isolating the medium in the liquid supplementing tank 21 from the external environment, thereby avoiding volatilization of the medium in the liquid supplementing tank 21. In addition, in the case of disposing the liquid supplementing valve 42 on the liquid supplementing pipeline 40, the liquid supplementing valve 42 can be closed as needed.

As shown in FIG. 4, in addition, in some optional embodiments, the liquid cooling system further includes a pressure relief subsystem 30, the pressure relief subsystem 30 includes a second electric valve 34 and a pressure relief pipeline 33, a first end of the pressure relief pipeline 33 is connected to the circulating main system 10, the second electric valve 34 is disposed on the pressure relief pipeline 33, and the control method further includes Step S230 or Step S240.

In S230, the second electric valve 34 is controlled to be opened in the case where the pressure is higher than a second set pressure value.

In S240, the second electric valve 34 is controlled to be closed in the case where the pressure is not higher than the second set pressure value.

In conjunction with the aforementioned pressurizing subsystem 20, pressure balance within the circulating main system 10 is maintained, and stable operation of the circulating main system 10 is ensured. In the embodiments of the present disclosure, in the case where the pressure is a set of pressures monitored at a plurality of positions, a maximum pressure is used as the pressure here in the pressure relief process.

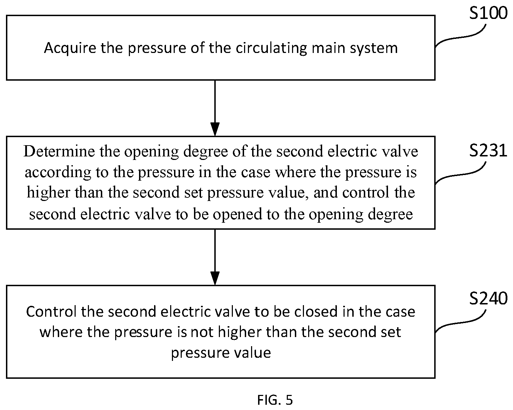

As shown in FIG. 5, in an optional embodiment, the step of controlling the second electric valve 34 to be opened includes S231, determining an opening degree of the second electric valve 34 according to the pressure, and controlling the second electric valve 34 to be opened to the opening degree. In this way, the pressure relief process can be accurately controlled, that the excessive high-pressure medium is prevented from being discharged during the pressure relief process.

In other optional embodiments, the pressure relief subsystem 30 includes a safety valve 31, a throttling pipe 32 and a pressure relief pipeline 33, the structure of which refers to the above. By means of the safety valve 31 and the throttling pipe 32, a large amount of high-pressure medium is prevented from being discharged during the pressure relief process, and stable pressure relief is ensured.

According to the liquid cooling system provided by the present disclosure, in the case where the circulating main system requires liquid supplementing, the medium inside the liquid supplementing tank can be drawn by means of the liquid supplementing pump to supplement the medium to the circulating main system, and after the first electric valve is opened, the air pressure of the liquid supplementing tank can be ensured to be balanced by air inlet through the pressure balance pipeline, while in the case where liquid supplementing is not needed, the pressure balance pipeline is disconnected through the first electric valve, so that external moisture or impurities can be prevented from entering the liquid supplementing tank, contamination of the medium is prevented, and dissipation of the medium stored in the liquid supplementing tank is prevented.

The above are merely optional embodiments of the present disclosure, and are not intended to limit the scope of the present disclosure, and equivalent structural changes made by using the contents of the description and the accompanying drawings of the present disclosure under the concept of the present disclosure, or directly/indirectly applied to other related technical fields are included in the protection scope of the present disclosure.

## Claims

1. A liquid cooling system, comprising:
a circulating main system, the circulating main system comprising a loop formed by sequentially connecting a medium cooling unit, an outer circulating pump, and a device cooling unit by means of pipelines, the medium cooling unit cooling a medium in the circulating main system, and the device cooling unit absorbing heat radiated from a device; and
a pressurizing subsystem and a liquid supplementing pipeline, the pressurizing subsystem comprising a first electric valve, a liquid supplementing tank, a liquid supplementing pump, and a pressure balance pipeline, the liquid supplementing tank being connected to the circulating main system by means of the liquid supplementing pipeline, the liquid supplementing pipeline being provided with the liquid supplementing pump, the pressure balance pipeline being further connected to the liquid supplementing tank, and the first electric valve being disposed on the pressure balance pipeline to control connection and disconnection of the pressure balance pipeline.

2. The liquid cooling system according to claim 1, wherein the pressurizing subsystem further comprises a dry filter, the dry filter is disposed on the pressure balance pipeline, the dry filter is located between the first electric valve and the liquid supplementing tank, and the dry filter dries air which passes through the pressure balance pipeline.

3. The liquid cooling system according to claim 1, further comprising a purification module, wherein the purification module is disposed on the liquid supplementing pipeline, and the purification module treats impurities in a medium.

4. The liquid cooling system according to any one of claims 1 to 3, wherein the circulating main system further comprises a degassing device, the medium cooling unit, the outer circulating pump, the degassing device and the device cooling unit are connected sequentially by means of pipelines to form the loop, the liquid supplementing pipeline is connected to the degassing device, and the degassing device separates gas in the circulating main system.

5. The liquid cooling system according to claim 4, further comprising an expansion tank, wherein the expansion tank is connected to the degassing device to receive separated gas in the degassing device, and the expansion tank carries out buffering and pressure stabilizing.

6. The liquid cooling system according to claim 1, further comprising a pressure relief subsystem, wherein the pressure relief subsystem comprises a safety valve, a throttling pipe, and a pressure relief pipeline, a first end of the pressure relief pipeline is connected to the circulating main system, the safety valve and the throttling pipe are disposed on the pressure relief pipeline, the safety valve is located between the circulating main system and the throttling pipe, and the throttling pipe restricts a flow rate of a discharged medium.

7. The liquid cooling system according to claim 1, further comprising a pressure relief subsystem, wherein the pressure relief subsystem comprises a second electric valve and a pressure relief pipeline, a first end of the pressure relief pipeline is connected to the circulating main system, and the second electric valve is disposed on the pressure relief pipeline.

8. The liquid cooling system according to claim 6 or 7, wherein the pressure relief subsystem further comprises a medium recovery device, and a second end of the pressure relief pipeline is connected to the medium recovery device.

9. The liquid cooling system according to any one of claims 1 to 3, wherein a plurality of the outer circulating pumps are provided, the plurality of the outer circulating pumps are arranged in parallel, and the medium cooling unit, the plurality of the outer circulating pumps which are arranged in parallel, and the device cooling unit are connected sequentially by means of pipelines to form the loop.

10. The liquid cooling system according to any one of claims 1 to 3, further comprising a control end and a pipeline monitoring sensor, wherein the pipeline monitoring sensor is disposed on the circulating main system, both the pipeline monitoring sensor and the first electric valve are connected to the control end, and the control end controls the first electric valve according to monitoring information of the pipeline monitoring sensor.

11. A control method for a liquid cooling system according to any one of claims 1 to 10, comprising:
acquiring a pressure of a circulating main system; and
controlling, in the case where the pressure is lower than a first set pressure value, a first electric valve to be opened, and controlling a liquid supplementing pump to be turned on to supplement liquid to the circulating main system; or
controlling, in the case where the pressure is not lower than a first set pressure value, the liquid supplementing pump to be turned off, and controlling the first electric valve to be closed.

12. The control method for the liquid cooling system according to claim 11, wherein the liquid cooling system further comprises a pressure relief subsystem, the pressure relief subsystem comprises a second electric valve and a pressure relief pipeline, a first end of the pressure relief pipeline is connected to the circulating main system, the second electric valve is disposed on the pressure relief pipeline, and the control method further comprises:
controlling, in the case where the pressure is higher than a second set pressure value, the second electric valve to be opened; or
controlling, in the case where the pressure is not higher than the second set pressure value the second electric valve to be closed.

13. The control method for the liquid cooling system according to claim 12, wherein the step of controlling the second electric valve to be opened comprises:
determining, according to the pressure, an opening degree of the second electric valve, and controlling the second electric valve to be opened to the opening degree.
